# EUROPEAN PATENT APPLICATION

(11) **EP 2 530 476 A2**
(43) Date of publication of application: **05.12.2012**
(21) Application number: 11190306.8
(22) Date of filing: 23.11.2011
(51) Int. Cl.: G01R 19/165

(54) **Phase detection apparatus for alternator and method thereof**

(30) Priority: 03.06.2011 TW 100119634
(71) Applicant: Actron Technology Corporation, Lu Chu Hsiang, Taoyuan County (TW)
(72) Inventor: Liu, Tung-Jung, 434 Taichung City (TW)
(74) Representative: Viering, Jentschura & Partner

(57) **Abstract**

A phase detection apparatus (2) for an alternator is disclosed according to an embodiment of the present invention. The phase detection apparatus (2) comprises a waveform detector (21), a threshold voltage generator (22), and a comparator (23). The waveform detector (21) is used for detecting a wave peak of a phase signal, and generating a waveform detection signal accordingly. The threshold voltage generator (22) is used for generating a reference signal according to the waveform detection signal. The comparator (23) is used for comparing the phase signal with the reference signal, and generating a comparison signal accordingly. Therefore, the phase detection apparatus (2) for the alternator may reduce the leakage current of a battery in a vehicle.

## Description

### BACKGROUND OF THE INVENTION

### 1. Field of the Invention

The present invention relates to a power generator of a vehicle; in particular, to a phase detection apparatus for an alternator and method thereof.

### 2. Description of Related Art

Vehicles are one form of transportation used today, each of which is usually equipped with a power generator and a storage battery. The power generator is used for providing electric power to electrical devices of the vehicle, and the storage battery is used for storing requisite electric power for starting the vehicle and/or backup power. For example, the kinetic energy of an engine which uses fossil fuels may be converted into alternating current signals of the power generator, and these alternating current signals could be stored in the storage battery by using rectifying circuits.

The power generator is usually a three-phase alternator, and each phase goes with a phase detection apparatus for detecting the phase and frequency of the alternating current signal generated by the alternator. When the alternator is at low speed or idle speed, the phase signal outputted by the armature of the alternator is carried on a direct current signal with an unfixed voltage value by a sinusoidal wave with small amplitude. In other words, the outputted phase signal is formed by adding the direct current signal and the alternating current signal together, wherein the voltage value of the direct current signal may be influenced by different leakage currents of different rectifying components. Because the voltage value of the direct current signal is not a fixed value, thus the alternating current signal needs to be retrieved for determining the phase and frequency of the alternating signal generated by the alternator.

Traditional manner is to pull-down the voltage value of the direct current signal for having the voltage value of the phase signal be near to zero volt by using a resistor connected to the ground, and then, retrieving the alternating current signal by a comparator.

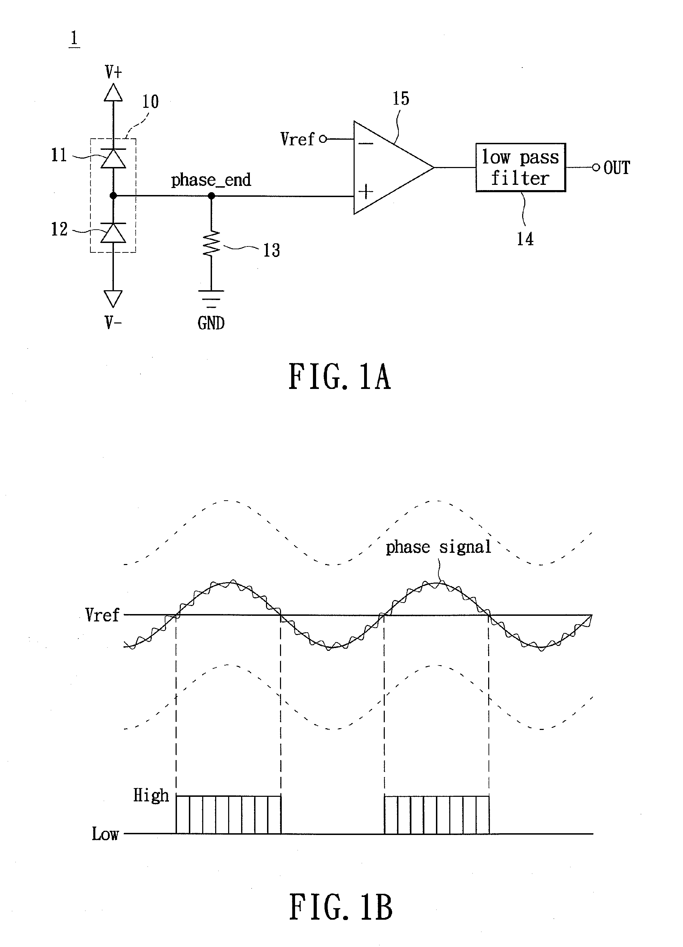

Please refer to FIG. 1A. FIG. 1A shows a circuit diagram of a traditional phase detection apparatus for an alternator. The traditional phase detection apparatus 1 comprises a rectifying unit 10, a resistor 13, a comparator 15, and a low pass filter 14. A phase signal terminal phase_end is used for receiving a phase signal generated by one of the armatures of the alternator. The phase signal terminal phase_end is electrically coupled to the rectifying unit 10, and is electrically coupled to ground GND through the resistor 13. The non-inverted input terminal of the comparator 15 is electrically coupled to the phase signal terminal phase_end, and the inverted input terminal of the comparator 15 receives a reference voltage Vref. The output terminal of the comparator 15 is electrically coupled to an output terminal OUT of the phase detection apparatus 1 through the low pass filter 14.

The rectifying unit 10 includes rectifying components 11, 12, which may be implemented by diodes. The input terminal of the rectifying component 11 and the output terminal of the rectifying component 12 are electrically coupled with the phase signal terminal phase_end, and the output terminal of the rectifying component 11 and the input terminal of the rectifying component 12 are electrically coupled to a positive terminal V+ and a negative terminal V- of a power source respectively.

The comparator 15 may compare the magnitudes of the phase signal and the reference voltage Vref, and output a comparison signal accordingly. The output terminal OUT of the traditional phase detection apparatus 1 may further be electrically coupled to a processing unit (not shown in FIG. 1A). The processing unit may acquire the phase and frequency of the alternating current signal generated by the alternator according to the change of the voltage level of the comparison signal.

The low pass filter 14 is used for filtering out the high frequency noise of the comparison signal, such that the errors cause by the high frequency noise may be avoided. In addition, the low pass filter 14 may be removed or be moved to be electrically coupled between the phase signal terminal phase_end and the non-inverted input terminal of the comparator 15.

Please refer to FIG. 1B. FIG. 1B shows a diagram of the waveforms of a comparison signal generated by a comparator and the phase signal with small amplitude sinusoidal wave. The waveform shown at the upper half of the FIG. 1B represents the phase signal of the phase signal terminal phase end. The phase signal carries small amplitude sinusoidal wave (alternating current signal). Because the voltage value of the direct current signal may varies due to leakage currents of different rectifying components, the waveform of the phase signal may shift vertically between the two dotted lines at the upper half of FIG. 1B.

The waveform shown at the lower half of FIG. 1B represents the comparison signal outputted by the comparator 15 on condition that the voltage value of the direct current signal is a fixed value. In this case, the change of the voltage level of the comparison signal may be used for deriving the phase and frequency of the alternating current signal. However, as described above, the voltage value of the direct current signal is not a fixed value, and the waveform curve of the phase signal may shift vertically between the two dotted lines at the upper half of FIG. 1B. Therefore, the reference voltage Vref may need to change its value according to the voltage value of the direct current signal. Otherwise, the phase detection apparatus 1 may not acquire the phase and frequency of the alternating current signal precisely.

Moreover, the mentioned manners may further cause increase of the leakage currents of the battery when the battery is in standby status. Especially, when the environment temperature is high, the leakage currents of the battery may increase dramatically, which may shorten the standby time of the battery, and the vehicle may be difficult to start up.

### SUMMARY OF THE INVENTION

The object of the present invention is to provide a phase detection apparatus for an alternator and method thereof.

In order to achieve the aforementioned objects, according to an embodiment of the present invention, a phase detection apparatus for an alternator is offered. The phase detection apparatus comprises a waveform detector, a threshold voltage generator, and a comparator. The waveform detector is used for detecting a wave peak of a phase signal, and for generating a waveform detection signal. The threshold voltage generator is for generating a reference signal according to the waveform detection signal. The comparator compares the phase signal and the reference signal, and outputs a comparison signal accordingly.

In order to achieve the aforementioned objects, according to an embodiment of the present invention, a phase detection method of an alternator is offered. The phase detection method is associated with a phase detection apparatus for the alternator, and the method comprises acquiring a peak value of a phase signal, and generating a wave peak detection signal accordingly; acquiring a trough value of the phase signal, and generating a wave trough detection signal accordingly; generating a reference signal according to the wave peak detection signal and the wave trough detection signal; and comparing the reference signal with the phase signal for generating a comparison signal.

In summary, the phase detection apparatus for an alternator and method thereof detect the wave peak of the phase signal (or detect the wave peak and wave trough of the phase signal at the same time) for generating the reference signal. In addition, the apparatus and method further use the comparator to compare the reference signal with the phase signal for determining changes of the value of the phase signal. Therefore, the present invention may keep the leakage currents of the battery in the vehicle at a smaller value, and may increase standby time of the battery in the vehicle.

For further understanding of the present disclosure, reference is made to the following detailed description illustrating the embodiments and examples of the present disclosure. The description is only for illustrating the present disclosure, not for limiting the scope of the claim.

### BRIEF DESCRIPTION OF THE DRAWINGS

The drawings included herein provide further understanding of the present disclosure. A brief introduction of the drawings is as follows:

FIG. 1A shows a circuit diagram of a traditional phase detection apparatus for a power generator;

FIG. 1B shows a diagram of the waveforms of a phase signal with small amplitude sinusoidal wave and a comparison signal outputted by a comparator;

FIG. 2 shows a block diagram of a phase detection apparatus for an alternator according to an embodiment of the present invention;

FIG. 3 shows a diagram of the waveforms of a low-pass filtered phase signal, a waveform detection signal, and a comparison signal of a phase detection apparatus for an alternator according to an embodiment of the present invention;

FIG. 4 shows a block diagram of a phase detection apparatus for an alternator according to another embodiment of the present invention;

FIG. 5 shows a diagram of the waveforms of a low-pass filtered phase signal, a waveform detection signal, and a comparison signal of a phase detection apparatus for an alternator according to another embodiment of the present invention; and

FIG. 6 shows a flow diagram of a phase detection method for an alternator according to an embodiment of the present invention.

### DETAILED DESCRIPTION OF THE PREFERRED EMBODIMENTS

The aforementioned illustrations and following detailed descriptions are exemplary for the purpose of further explaining the scope of the present invention. Other objectives and advantages related to the present invention will be illustrated in the subsequent descriptions and appended drawings.

[An embodiment of a phase detection apparatus for an alternator]

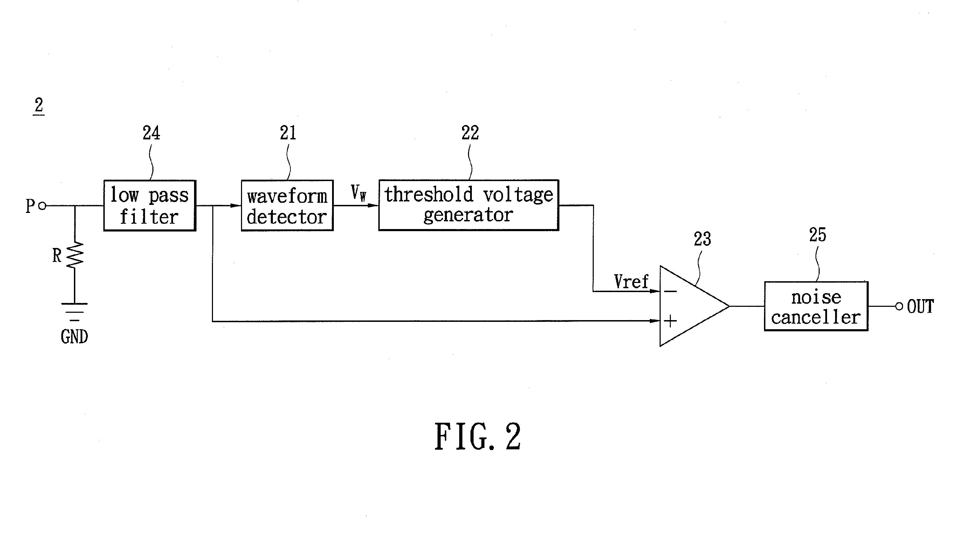

Please refer to FIG. 2. FIG. 2 shows a block diagram of a phase detection apparatus for an alternator according to an embodiment of the present invention. The phase detection apparatus 2 for the alternator comprises a waveform detector 21, a threshold voltage generator 22, a comparator 23, a low pass filter 24, a noise canceller 25, and a resistor R.

One end of the resistor R is electrically coupled to a phase signal P while the other end is electrically coupled to a ground GND. An input terminal of the low pass filter 24 receives the phase signal P, and is also electrically coupled to the ground GND through the resistor R. An output terminal of the low pass filter 24 is electrically coupled to an input terminal of the waveform detector 21 and a non-inverted input terminal of the comparator 23. An output terminal of the waveform detector 21 is electrically coupled an input terminal of the threshold voltage generator 22. An output terminal of the threshold voltage generator 22 is electrically coupled to an inverted input terminal of the comparator 23. An output terminal of the comparator 23 is electrically coupled to an input terminal of the noise canceller 25. An output terminal of the noise canceller 25 is electrically coupled to an output terminal OUT of the phase detection apparatus 2 for the alternator.

The waveform detector 21 is used for detecting a wave peak of the phase signal P after that the phase signal P is low-pass filtered, and for generating a waveform detection signal V_{w}. The waveform detection signal V_{w} generated by the waveform detector 21 represents a peak value of the low-pass filtered phase signal P. The threshold voltage generator 22 is used for generating a reference signal Vref according to the waveform detection signal V_{w}. The reference signal Vref generated by the threshold voltage generator 22 may be used for determining whether a voltage value of the low-pass filtered phase signal P is near to the wave peak or not. The comparator 23 compares the low-pass filtered phase signal P with the reference signal Vref, and generates a comparison signal. The comparison signal generated by the comparator 23 may represent whether the voltage value of the low-pass filtered phase signal P is near to the wave peak or not.

In this embodiment, the comparator 23 may be a differential voltage comparator, such that the comparator 23 may be able to compare the voltage difference between the non-inverted input terminal and the inverted input terminal. The inverted input terminal of the comparator 23 of this embodiment receives the reference signal Vref, and the non-inverted input terminal of the comparator 23 receives the low-pass filtered phase signal P. However, the connection manner of the comparator 23 according to the present invention is not restricted thereby. That is, the connections of the non-inverted input terminal and the inverted input terminal of the comparator 23 may interchange which each other, and after interchanging, the comparator 23 just outputs a signal opposite to the original one. An artisan of ordinary skill in the art will appreciate the implementation manner, thus there is no need to go into details.

The low pass filter 24 may filter out the high frequency noise of the phase signal P, for avoiding detection errors caused by the high frequency noise. The noise canceller 25 may filter out the noise of the comparison signal outputted by the comparator 23. However, the implementation is not restricted thereby. In practical applications, if the high frequency noise lies in an acceptable range, at least one of the low pass filter 24 and the noise canceller 25 may be removed. If the low pass filter 24 and the noise canceller 25 are both removed, the input terminal of the waveform detector 21 may receive the phase signal P directly. Meanwhile, the output terminal of the comparator 23 may directly and electrically coupled to the output terminal OUT of the phase detection apparatus 2 for the alternator. In addition, the low pass filter 24 and the noise canceller 25 may be an analog filter or a digital filter, that is, the types of the low pass filter 24 and the noise canceller 25 are not restricted thereto.

The resistor R is used for reducing the voltage of the phase signal P to the voltage level which is acceptable to the waveform detector 21. However, the present invention is not restricted thereto. The resistor R is used for the sake of circuit design convenience. In practical applications, the resistor R may be removed by appropriate circuit design.

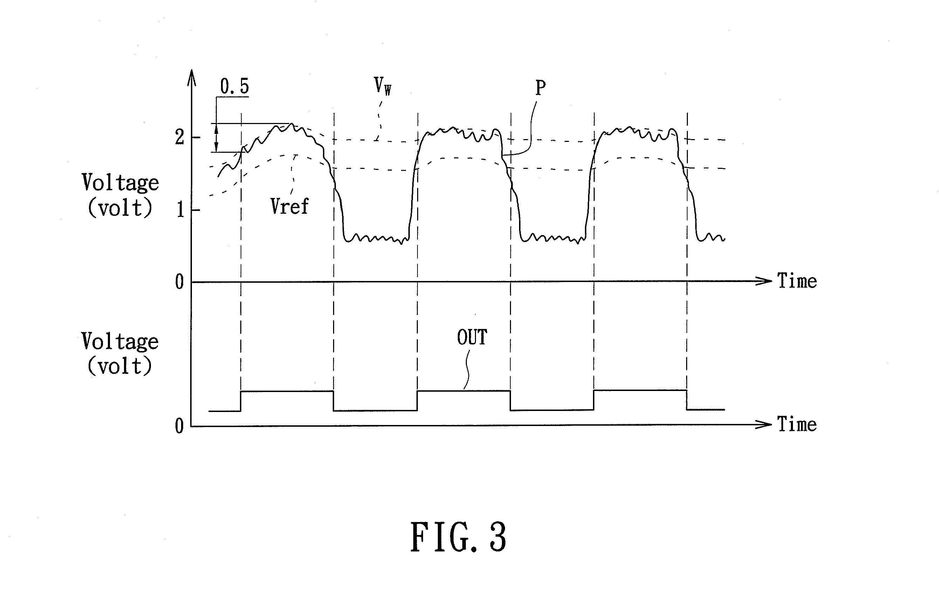

Please refer to FIG. 2 and FIG. 3. FIG. 3 shows a diagram of the waveforms of the low-pass filtered phase signal, the waveform detection signal, and the comparison signal for an alternator according to an embodiment of the present invention. The low-pass filtered phase signal P may still carry some noises or signals which are generated by the alternator when the alternator is in operation, such that the low-pass filtered phase signal P has ripples near the wave peaks. As shown in FIG. 3, the voltage value of the wave peak of the low-pass filtered phase signal P is 2 volt, the voltage value of the wave trough is close to zero volt, and the voltage value of the ripple near the wave peak is 0.5 volt. The ripple may influence the result of determining whether the phase signal P is near to the wave peak or not. In other words, if the low-pass filtered phase signal P is near to the wave peak, the operation of determining whether or not the phase signal P is near to the wave peak according to the reference signal Vref may not work properly, because the ripples may make the phase signal P smaller than the reference signal Vref.

For correctly determining whether the low-pass filtered phase signal P is located near to the wave peak or not, the value of the reference signal Vref is designed to be smaller than the voltage value of the wave peak of the low-pass filtered phase signal P minus the voltage value of the ripple. In other words, the reference signal Vref may be smaller than the waveform detection signal V_{W} minus a predetermined value, and the predetermined value may be the voltage value of the ripple near to the wave peak of the low-pass filtered phase signal P. As shown in FIG. 3, when the voltage value of the ripple is 0.5 volt, the predetermined value may be set to 0.5 volt, and the voltage value of the reference signal Vref may be around 1.2 volt. Therefore, as long as the phase signal P is near to the wave peak, the reference signal Vref may be smaller than the phase signal P for avoiding determination errors.

Please refer to FIG. 3 again. As shown in FIG. 3, when the voltage value of the low-pass filtered phase signal P is larger than the reference signal Vref, the comparator 23 may output the comparison signal with a high voltage level, which indicates that the low-pass filtered phase signal P is near to the wave peak. On the other hand, when the voltage value of the low-pass filtered phase signal P is smaller than the reference signal Vref, the comparator 23 may output the comparison signal with a low voltage level, which indicates that the phase signal P is not near to the wave peak. Because the summation of the time length when the phase signal P is larger than the reference signal Vref and the time length when the phase signal P is smaller than the reference signal Vref must be one period, thus the summation of the time length when the comparison signal is at the high voltage level and the time length when the comparison signal is at the low voltage level equals to the time length of one period. In other words, the frequency of the low-pass filtered phase signal P may be derived according to the change of the voltage level at the output terminal OUT.

After that, the comparison signal outputted by the comparator 23 is transmitted to the output terminal OUT of the phase detection apparatus 2 for the alternator through the noise canceller 25. The output terminal OUT of the phase detection apparatus 2 may be electrically coupled to a processing unit (not shown in FIG. 2), which may acquire the phase and frequency of the low-pass filtered phase signal P according to change of the voltage level at the output terminal OUT of the phase detection apparatus 2.

[Another embodiment of a phase detection apparatus for an alternator]

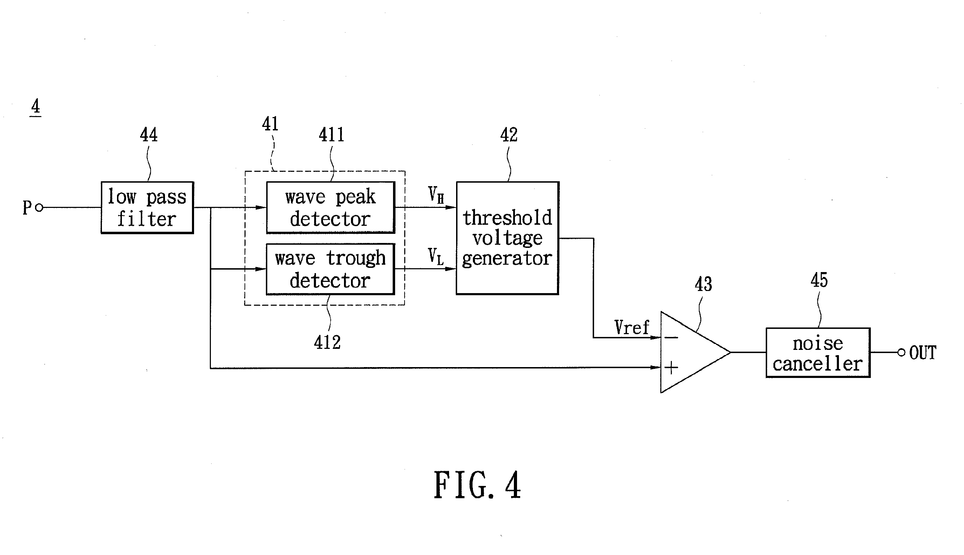

Please refer to FIG. 4. FIG.4 shows a block diagram of a phase detection apparatus for an alternator according to another embodiment of the present invention. The phase detection apparatus 4 for the alternator includes a waveform detector 41, a threshold voltage generator 42, a comparator 43, a low pass filter 44, and a noise canceller 45. Comparing with the phase detection apparatus 2 in FIG. 2, the waveform detector 41 of the phase detection 4 comprises a wave peak detector 411 and a wave trough detector 412.

The low pass filter 44 receives the phase signal P, and output terminal of the low pass filter 44 is electrically coupled to the input terminals of the wave peak detector 411 and the wave trough detector 412 and the non-inverted input terminal of the comparator 43. The output terminals of the wave peak detector 411 and the wave trough detector 412 are electrically coupled to the input terminal of the threshold voltage generator 42. The output terminal of the threshold voltage generator 42 is electrically coupled to the inverted input terminal of the comparator 43. The output terminal of the comparator 43 is electrically coupled to the input terminal of the noise canceller 45. The output terminal of the noise canceller 45 is electrically coupled to the output terminal OUT of the phase detection apparatus 4 for the alternator.

The waveform detector 41 is for detecting the wave peak and wave trough of the low-pass filtered phase signal P, and generating a waveform detection signal which comprises a wave peak detection signal V_{H} and a wave trough detection signal V_{L}. The wave peak detector 411 of the waveform detector 41 generates the wave peak detection signal V_{H} while the wave trough detector 412 generates the wave trough detection signal V_{L}. The threshold voltage generator is used for generating a reference signal Vref according to the wave peak detection signal V_{H} and the wave trough detection signal V_{L}. The reference signal Vref is used for determining whether the voltage of the low-pass filtered phase signal P is near to the wave peak or the wave trough. The comparator 43 compares the phase signal P with the reference signal Vref. A comparison signal outputted by the comparator 43 may represent that the low-pass filtered phase signal P is near to the wave peak or wave trough.

In this embodiment, the comparator 43, the low pass filter 44, and the noise canceller 45 may be the same as the comparator 23, the low pass filter 24, and the noise canceller 25 in the previous embodiment respectively, thus there is no need to go into details.

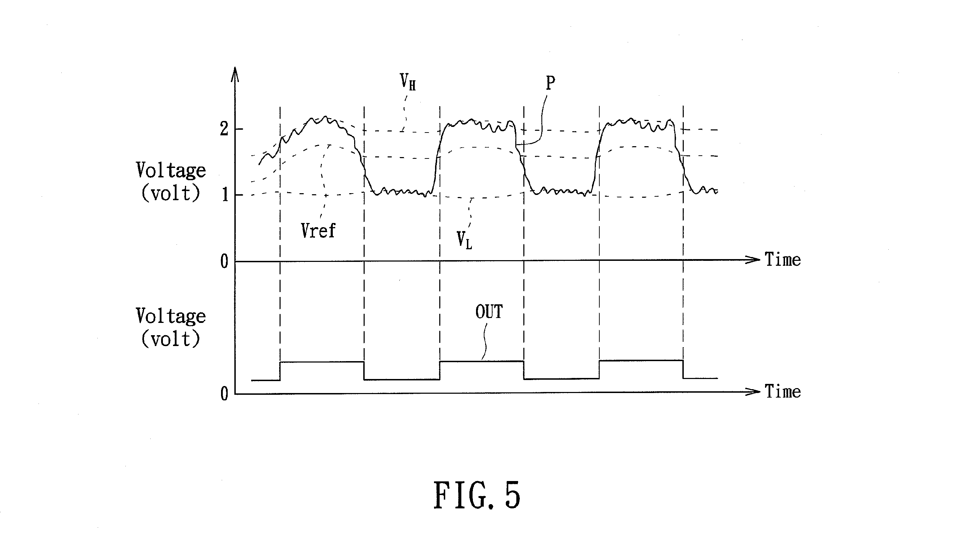

Please refer to FIG. 4 and FIG. 5. FIG. 5 shows a diagram of the waveforms of the low-pass filtered phase signal, the waveform detection signal, and the comparison signal of the phase detection apparatus for the alternator according to another embodiment of the present invention. For correctly determining whether the phase signal P is near to the wave peak or not, voltage value of the reference signal Vref may be designed to be smaller than the voltage value of the peak value of the low-pass filtered phase signal P minus the voltage value of the ripple. Additionally, in this embodiment, the wave trough of the low-pass filtered phase signal P is not close to zero volt. In other words, the trough value of the low-pass filtered phase signal P may not be ignored. Thus, voltage value of the reference signal Vref is smaller than the voltage value of the wave peak detection signal V_{H} minus the voltage value of the ripple, and is larger than the voltage value of the wave trough detection signal V_{L}.

The reference signal Vref is smaller than the voltage value of the wave peak detection signal V_{H} minus a predetermined value. As shown in FIG. 5, if the peak value of the low-pass filtered phase signal P is 2 volt, the voltage value of the ripple which is near to the wave peak of the low-pass filtered phase signal P is 0.5 volt, and the trough value of the low-pass filtered phase signal P is 1 volt, then the voltage value of the reference signal Vref may be between 1 volt and 1.5 volt (which is 2 volt minus 0.5 volt).

Please refer to FIG. 5 again. As shown in FIG. 5, when the voltage value of the low-pass filtered phase signal P is larger than the reference signal Vref, the comparator 43 may output the comparison signal with a high voltage level for indicating that the phase signal P is near to the wave peak. On the other hand, when the voltage value of the low-pass filtered phase signal P is smaller than the voltage value of the reference signal Vref, the comparator 43 may output the comparison signal with a low voltage level for indicating that the phase signal P is near to the wave trough. Because the summation of the time length when the low-pass filtered phase signal P is larger than the reference signal Vref and the time length when the low-pass filtered phase signal P is smaller than the reference signal Vref must be one period, the time length when the comparison signal is at the high voltage level and the time length when the comparison signal is at the low voltage level equals to the time length of one period. In other words, the frequency of the low-pass filtered phase signal P may be derived according to the change of the voltage level at the output terminal OUT.

After that, the comparison signal outputted by the comparator 43 is transmitted to the output terminal OUT of the phase detection apparatus 4 for the alternator through the noise canceller 45. The output terminal OUT of the phase detection apparatus 4 may be electrically coupled to a processing unit (not shown in FIG. 4), such that the processing unit may acquire the phase and frequency of the low-pass filtered phase signal P according to the change of the voltage level at the output terminal OUT of the phase detection apparatus 4.

[An embodiment of a phase detection method for an alternator]

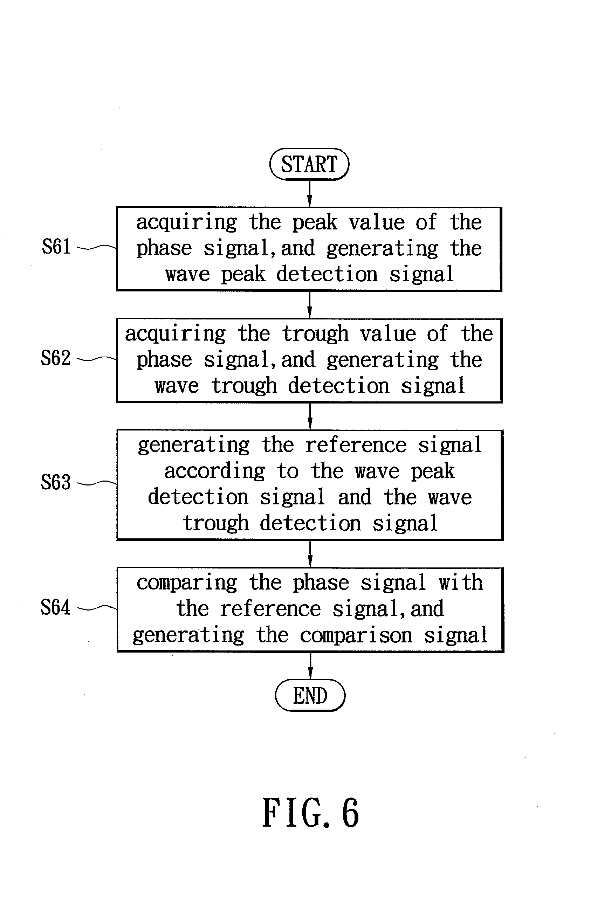

Please refer to FIG. 6. FIG. 6 shows a flow diagram of a phase detection method for an alternator according to an embodiment of the present invention. The phase detection method is used in a phase detection apparatus for the alternator. The phase detection method comprises the following steps. Firstly, in step S61, the phase detection apparatus acquires a peak value of a phase signal, and generates a peak value detection signal. In step S62, the phase detection apparatus acquires a trough value of the phase signal, and generates a trough detection signal. Then, in step S63, the phase detection apparatus generates a reference signal according to the wave peak detection signal and the wave trough detection signal. After that, in step S64, the phase detection apparatus compares the phase signal with the reference signal for acquiring a comparison signal.

In this embodiment, the phase detection method for the alternator may be implemented in the phase detection apparatus 4 in FIG. 4. In step S63, if the reference signal is implemented in the form of voltage, the voltage value of the reference signal may be smaller than the voltage value of the wave peak detection signal minus a predetermined value. The predetermined value may be the voltage value of a ripple near to the wave peak of the phase signal. Furthermore, the voltage value of the reference signal may be larger than the voltage value of the wave trough detection signal.

In addition, in step S61, the phase detection method may include a step of filtering out the high frequency noise of the phase signal. In step S64, the phase detection method may further comprise a step of filtering out the noise of the comparison signal.

According to aforementioned embodiments of the present invention, the described phase detection apparatus and method detect the wave peak of the phase signal (or detect the wave peak and wave trough of the phase signal at the same time), in order to generate the reference signal. In addition, the apparatus and method further use the comparator to compare the reference signal with the phase signal for determining variations of the phase signal. Therefore, the present invention may keep the leakage currents of a battery in a vehicle at a smaller value, and may increase the standby time of the battery in the vehicle.

Some modifications of these examples, as well as other possibilities will, on reading or having read this description, or having comprehended these examples, will occur to those skilled in the art. Such modifications and variations are comprehended within this disclosure as described here and claimed below. The description above illustrates only a relative few specific embodiments and examples of the present disclosure. The present disclosure, indeed, does include various modifications and variations made to the structures and operations described herein, which still fall within the scope of the present disclosure as defined in the following claims.

## Claims

1. A phase detection apparatus (2) for an alternator, comprising:
a waveform detector (21), for detecting a wave peak of a phase signal, and for generating a waveform detection signal accordingly;
a threshold voltage generator (22), for generating a reference signal according to the waveform detection signal; and
a comparator (23), for comparing the phase signal and the reference signal, and for generating a comparison signal accordingly.

2. The phase detection apparatus (2) for the alternator according to claim 1, wherein the waveform detector (21) further detects a wave trough of the phase signal, and the waveform detection signal includes a wave peak detection signal and a wave trough detection signal, wherein the wave peak detection signal and the wave trough detection signal are generated according to the wave peak and the wave trough of the phase signal respectively, and the threshold voltage generator (22) generates the reference signal according to the wave peak detection signal and the wave trough detection signal.

3. The phase detection apparatus (2) for the alternator according to claim 1, wherein a voltage value of the reference signal is smaller than a voltage value of the waveform detection signal minus a predetermined value.

4. The phase detection apparatus (2) for the alternator according to claim 2, wherein a voltage value of the reference signal is smaller than a voltage value of the wave peak detection signal minus a predetermined value, and the voltage value of the reference signal is larger than a voltage value of the wave trough detection signal.

5. The phase detection apparatus (2) for the alternator according to claim 1, further comprising:
a low pass filter (24), electrically coupled to the waveform detector (21), wherein the low pass filter (24) is an analog filter or a digital filter.

6. The phase detection apparatus (2) for the alternator according to claim 1, further comprising:
a noise canceller (25), electrically coupled to an output terminal of the comparator (23), wherein the noise canceller (25) is an analog filter or a digital filter.

7. A phase detection method for an alternator, which is associated with a phase detection apparatus (2) for the alternator, the method comprising:
acquiring a peak value of a phase signal, and generating a wave peak detection signal accordingly;
acquiring a trough value of the phase signal, and generating a wave trough detection signal accordingly;
generating a reference signal according to the wave peak detection signal and the wave trough detection signal; and
comparing the phase signal with the reference signal for generating a comparison signal.

8. The phase detection method for the alternator according to claim 7, wherein a voltage value of the reference signal is smaller than a voltage value of the wave peak detection signal minus a predetermined value, and the voltage value of the reference signal is larger than a voltage value of the wave trough detection signal.

9. The phase detection method for the alternator according to claim 7, further comprising:
filtering out the high frequency noise of the phase signal; and
filtering out the noise of the comparison signal.
